# EUROPEAN PATENT APPLICATION

(11) **EP 3 754 673 A1**
(43) Date of publication of application: **23.12.2020**
(21) Application number: 19755074.2
(22) Date of filing: 14.02.2019
(51) Int. Cl.: H01F 1/37, C01G 49/00, C01G 49/02, H01F 1/34, H05K 9/00

(54) **MAGNETIC MATERIAL, METHOD FOR PRODUCING SAME, AND SHEET FOR ELECTROMAGNETIC WAVE ABSORPTION**

(30) Priority: 15.02.2018 JP 2018025399
(71) Applicant: The University of Tokyo, Bunkyo-ku, Tokyo 113-8654 (JP); DOWA ELECTRONICS MATERIALS CO., LTD., Chiyoda-ku Tokyo 101-0021 (JP)
(72) Inventor: OHKOSHI Shin-ichi, Tokyo 113-8654 (JP); NAMAI Asuka, Tokyo 113-8654 (JP); YOSHIKIYO Marie, Tokyo 113-8654 (JP); GOTOH Masahiro, Tokyo 101-0021 (JP); UEYAMA Toshihiko, Tokyo 101-00021 (JP); YOSHIDA Takayuki, Tokyo 101-0021 (JP)
(74) Representative: Müller-Boré & Partner Patentanwälte PartG mbB
(86) International application number: PCT/JP2019/005354
(87) International publication number: WO 2019/160040

(57) **Abstract**

There is provided a magnetic material that has an excellent electromagnetic wave absorption performance in a wide frequency range even under low temperature and high temperature environments and that ensures the absorption performance, and provided a magnetic material as a mixture of a magnetic material having positive slope of change in coercive force dependent on temperature, and a magnetic material having negative slope of change in coercive force dependent on temperature.

## Description

### Technical Field

The present invention relates to a magnetic material suitable for absorbing electromagnetic waves (millimeter waves) and a method for producing the same, and an electromagnetic wave absorbing sheet using the magnetic material.

### Description of Related Art

A millimeter-wave radar is characterized by high resolution. A detection technology using the millimeter-wave radar can detect pedestrians and bicycles with high accuracy even in bad weather or at night, and therefore in recent years, it has been expected as a next-generation ITS sensor that enables to grasp a condition around a vehicle and monitor an inside of an intersection.

On the other hand, in order to further improve the resolution and reliability of the millimeter-wave radar, an electromagnetic wave absorber for removing unnecessary electromagnetic noise is required.

The present inventors have studied iron oxide having a unique property called epsilon iron oxide for many years. Patent document 1 discloses that a frequency band of absorbed electromagnetic waves can be set to a desired value, by setting a type and an amount of substitution element to a predetermined value, and further discloses that the frequency band of the absorbed electromagnetic waves can be set to a desired range over a wide range from low frequency to high frequency.

On the other hand, patent document 2 discloses a magnetoplumbite type hexagonal ferrite powder for an electromagnetic wave absorber as a material having an electromagnetic wave absorption performance, in which a peak particle size of a laser diffraction scattering particle size distribution is 10 µm or more, and a composition formula is represented by AFe₍₁₂₋ₓ₎AlₓO₁₉ (where A is at least one of Sr, Ba, Ca and Pb, x : 1.0 to 2.2), and discloses that an electromagnetic wave having a specific frequency can be removed by using an electromagnetic wave absorbing magnetic sheet prepared by adding the hexagonal ferrite.

### Prior Art Document

### Patent Document

[Patent Document 1] Japanese Patent No. 4787978
[Patent Document 2] Japanese Patent No. 4674380

### Summary of the Invention

### Problem to be solved by the Invention

The present inventors have found that an electromagnetic wave absorption performance of epsilon iron oxide is greatly affected by a coercive force of the substance. Specifically, by adjusting the coercive force of the substance by adjusting a particle size of epsilon iron oxide or a substitution element, an absorption frequency band of the substance can be arbitrarily adjusted over a wide range of 35 to 220 GHz.

On the other hand, according to a technique relating to the electromagnetic wave absorbing sheet disclosed in Patent Document 2, millimeter-wave and quasi-millimeter-wave electromagnetic waves can be absorbed by adjusting a thickness of the electromagnetic wave absorbing sheet that contains strontium ferrite.

However, according to further studies by the present inventors, an electromagnetic wave absorbing ability of the substance having the electromagnetic wave absorption performance according to these conventional techniques is still low, and a material having higher electromagnetic wave absorbing ability has been requested.

Further, it is found that electromagnetic wave absorbing properties of an electromagnetic wave absorbing material using ferrite according to the conventional art is significantly changed due to a change in the ambient temperature. Therefore, great deterioration of the resolution and reliability due to the change in the ambient temperature environment is concerned, which is caused by an uneven amount of removable electromagnetic waves due to the change in the ambient temperature environment. Especially, when considering an application to a millimeter-wave radar for vehicles, vehicle safety is concerned by such a property of the electromagnetic wave absorbing material that uses ferrite, namely, the property such that the resolution and reliability are greatly affected by the change in the ambient temperature environment.

The present invention has been made in view of the above situation, and a problem to be solved by the present invention is to provide a magnetic material that has an excellent electromagnetic wave absorption performance in a wide frequency range even under low temperature and high temperature environments and that ensures the absorption performance.

### Means for solving the Problem

According to a study conducted by the present inventors, it is found that the above-described problem can be solved when the magnetic material has the following properties, and the present invention is completed.

Namely, the present invention provides a magnetic material as a mixture of a magnetic material having positive slope of change in coercive force dependent on temperature, and a magnetic material having negative slope of change in coercive force dependent on temperature, that has an excellent electromagnetic wave absorption performance in a wide frequency range even under low temperature and high temperature environment and ensures the absorption performance.

Further, the present inventors found that hexagonal ferrite can be preferably used as a magnetic material having positive slope of change in coercive force dependent on temperature, and epsilon iron oxide can be preferably used as a magnetic material having negative slope of change in coercive force dependent on temperature.

Namely, in order to solve the above-described problem, a first invention provides a magnetic material as a mixture of a magnetic material having positive slope of change in coercive force dependent on temperature, and a magnetic material having negative slope of change in coercive force dependent on temperature.

A second invention provides a magnetic material containing epsilon iron oxide and hexagonal ferrite.

A third invention provides a magnetic material consisting of epsilon iron oxide and hexagonal ferrite.

A fourth invention provides a method for producing a magnetic material, including:
mixing epsilon iron oxide, hexagonal ferrite, and a dispersion medium and performing a dispersion treatment to obtain a mixture; and
performing solid-liquid separation operation on the mixture to recover a solid component.

A fifth invention provides an electromagnetic wave absorbing sheet containing the magnetic material according to any one of the first to third inventions.

### Advantage of the Invention

By using the magnetic material of the present invention as an electromagnetic wave absorbing material, excellent electromagnetic wave absorption performance is exhibited in a high frequency range even under low temperature and high temperature environments, and the absorption performance is ensured even under low temperature and high temperature environments.

### Detailed Description of the Invention

As a conventional technique, there is a technique of obtaining a magnetic material by mixing two or more types of hexagonal ferrite. However, examination by the present inventors reveals that when the ambient temperature rises, it is inevitable that the electromagnetic wave absorption in the low frequency range will decrease even when two or more types of hexagonal ferrite are mixed to obtain the magnetic material.

Further examination of this phenomenon reveals that there is a correlation between the slope of change in coercive force dependent on temperature due to the change in the ambient temperature environment, and a shift direction of an absorption property peak position due to the change in the ambient temperature environment. The above finding also reveals that a decrease in the amount of electromagnetic wave absorption in the low frequency range is unavoidable in the magnetic material containing two or more types of hexagonal ferrite.

That is, in the case of the mixture of the hexagonal ferrites, it can be considered that due to positive slope of change in coercive force dependent on temperature, the frequency that allows the electromagnetic wave absorption shifts to a high frequency side when the ambient temperature rises, and the electromagnetic wave absorption at the low frequency side decreases.

In the present invention, the "slope of change in coercive force dependent on temperature", namely, the coercive force that changes due to change in the ambient temperature environment means a quantification of how the coercive force changes due to an influence of the ambient temperature environment, and specifically means the slope of a straight line when the change in the coercive force between the temperatures at two specific points is approximated by a straight line.

That is, in the magnetic material having the positive slope of change in coercive force dependent on ambient temperature, the coercive force also rises as the ambient temperature rises and the electromagnetic wave frequency shifts to the high frequency side. On the other hand, in the magnetic material having the negative slope of change in coercive force dependent on temperature, the coercive force decreases as the ambient temperature rises and the electromagnetic wave frequency shifts to the low frequency side.

Then, the present inventors achieve a configuration such that the mixture of the magnetic material having positive slope of change in coercive force dependent on ambient temperature, and the magnetic material having negative slope of change in coercive force dependent on ambient temperature, is capable of suppressing the amount of change while ensuring electromagnetic wave absorption property regardless of change in the ambient temperature environment.

That is, by mixing the magnetic material whose peak wavelength of electromagnetic wave absorption property shifts to the high frequency and the material whose peak wavelength of electromagnetic wave absorption property shifts to the lower frequencies side along with a rise of the ambient temperature, both materials will cover each other's decrease in electromagnetic wave absorption even if the ambient temperature environment changes, and excellent electromagnetic wave absorption property can be ensured in a wide temperature range and a wide frequency band.

Further, the present inventors also achieve the magnetic material obtained by mixing hexagonal ferrite which is the magnetic material having positive slope of change in coercive force dependent on ambient temperature, and epsilon iron oxide which is the magnetic material having negative slope of change in coercive force dependent on ambient temperature, and also achieve an electromagnetic wave absorbing sheet using the magnetic material.

The present invention will be described hereafter in an order of [1] Epsilon iron oxide and method for producing the same, [2] Hexagonal ferrite and method for producing the same, [3] Magnetic material according to the present invention and method for producing the same, [4] Electromagnetic wave absorbing sheet according to the present invention, and method for producing the same.

### [1] Epsilon iron oxide and method for producing the same

Epsilon iron oxide having the same space group as ε-Fe₂O₃ crystal, or having a structure in which a part of Fe site of the ε-Fe₂O₃ crystal is substituted with a different metal element, is selected as the epsilon iron oxide of the present invention. The epsilon-type iron oxide in which a part of Fe site of the ε-Fe₂O₃ crystal is substituted with a different metal element is sometimes called "substitution-type epsilon iron oxide". Here, a different metal element may have a structure of either a trivalent element alone or a combination of a divalent element and a tetravalent element.

The method for producing epsilon iron oxide is not particularly limited, and any known method other than the method disclosed by the present inventors in Patent Document 1 can be adopted.

In the present invention, a primary particle size calculated from the TEM photograph of epsilon iron oxide particles is preferably 1 to 100 nm on average, and more preferably about 1 to 50 nm.

### <Substitution of only one element other than Fe>

By substituting a part of Fe site of ε-Fe₂O₃ crystal composing the epsilon iron oxide with a trivalent element (eg, Al, Ga, In, etc.), the coercive force can be adjusted and can be a target of the present invention. In this case, strictly speaking, a crystal composition is expressed as ε-MₓFe₂₋ₓO₃, where M is a substitution element which is a trivalent metal element. Specifically, ε-MₓFe₂₋ₓO₃ crystal in which part of Fe site of ε-Fe₂O₃ crystal is substituted with trivalent M element, namely, crystal with the same space group as ε-Fe₂O₃ crystal, can be the target of the present invention.

### <Substitution of two or three different elements other than Fe>

Epsilon-type magnetic iron oxide particles represented by ε-Fe₂O₃ composing epsilon iron oxide having a structure in which a part of Fe³⁺ ion site is substituted with two or three different metal elements, may be preferably used. Specifically, epsilon-type magnetic iron oxide particles represented by a general formula: ε-AₓB_{y}Fe_{2-x-y}O₃ or ε-AₓB_{y}C_{z}Fe_{2-x-y-z}O₃ (where A, B and C are different metal elements other than Fe, and 0<x,y , z<1.) may be used.

Other than the elements described in the above formula, inclusion of components or compounds which are impurities generated during production may be allowed.

Here, two or three types of metal elements A, B, and C different from each other will be described.

In order to keep a crystal structure of ε-Fe₂O₃ stable, it is preferable to use a divalent metal element as A, a tetravalent metal element as B, and a trivalent metal element as C. Further, A is at least one metal element selected from Co, Ni, Mn, and Zn, B is Ti, and C is at least one metal element selected from In, Ga, and Al, as preferable examples. The reason why Fe is removed from A, B, and C is that a part of Fe³⁺ ion site of ε-Fe₂O₃ is substituted with two or three different metal elements.

### <Range of x, y, z>

First, the values of x and y when x represents a substitution amount of the divalent metal element and y represents a substitution amount of the tetravalent metal element will be described. x and y may be in a range of 0<x and y<1, and x and y can be arbitrarily combined. However, preferably x≈y, and more preferably x=y from a viewpoint of stability. This is because the number of electron defects in the particles is reduced and a stable substance can be obtained.

Here, in the case of 0≠x, y, the coercive force of the epsilon-type magnetic iron oxide particles according to the present invention can be controlled. However, when a control width of the target coercive force is large, 0.01≤x and 0.01≤y are preferable. Accordingly, from the above finding, the ranges of x and y are 0<x<1 and 0<y<1, preferably 0.01≤x<1, and 0.01≤y<1, more preferably 0.01≤x≤0. 5 and 0.01≤y≤0.5. Further, x≈y is preferable, and x=y is more preferable.

By adding a different element to the epsilon-type magnetic iron oxide particles according to the present invention so as to satisfy the above-described structure, Hc of the magnetic material can be controlled relatively easily by adjusting an amount of a substitution element, and therefore the frequency of radio wave absorption can be appropriately changed.

Next, the value of z in the case where z represents the substitution amount of the trivalent metal element will be described. Similarly to x and y, z may be in a range of 0<z<1, and more preferably in a range of 0<z≤0.5. By adding C element to the epsilon-type magnetic iron oxide particles according to the present invention, the coercive force of the particles can be arbitrarily controlled and, in addition, a single phase of ε-Fe₂O3 can be easily obtained, which is preferable. Depending on the purpose and application, when a single phase is required as the epsilon type magnetic iron oxide particles, three elements of A, B and C are added, and when a composite phase structure is acceptable, two elements A and B may be added. Any epsilon-type iron oxide having the above structure can be the target of the present invention.

### [2] Hexagonal ferrite and method for producing the same

As the hexagonal ferrite according to the present invention, magnetoplumbite-type hexagonal ferrite known to absorb radio waves, and represented by a general formula: AFe₍₁₂₋ₓ₎AlₓO₁₉ (where A is one or more elements selected from Sr, Ba, Ca and Pb, and x is 1.0 or more.2. 2 or less), may be used.

Further, magnetoplumbite-type hexagonal ferrite represented by a composition formula of AFe_{(12-X)}(Bl_{0.5}B2_{0.5})xO₁₉ may be used as the magnetoplumbite-type hexagonal ferrites in which a part of Fe³⁺ is substituted with another element. Here, A is one or two kinds of Ba and Sr, B1 is one or two kinds of Ti and Zr, and B2 is a divalent metal element. Particularly, two or more kinds of Co, Mn, Cu, Mg, Zn, and Ni may be contained as the B2 element having the above composition formula. As a method for producing the hexagonal ferrite, any of conventionally known production methods can be preferably used in addition to the production method described in Patent Document 2.

### [3] Magnetic material according to the present invention and method for producing the same

A method for producing magnetic powder including: mixing the magnetic powder having the above-described structure and making the mixture subjected to a dispersion treatment after adding to a dispersion medium, and subjected to a solid-liquid separation operation to collect solid components. Here, the dispersion treatment may be any treatment that can uniformly mix different magnetic powders in a solvent. It is preferable to employ a so-called homogenizer treatment. An ultrasonic type that causes cavitation using ultrasonic waves and atomizes the particles, a stirring type that performs stirring and atomizes the particles, and a high pressure type that applies pressure and atomizes the particles, are known as a homogenizer. There are a nozzle type and a valve type in the high pressure type, but either type can be adopted. Further, for a dispersion treatment, it is preferable to use a disperser capable of giving a shearing force, and particularly, a turbine-stator type stirrer is preferable.

From the above viewpoint, a commercial example of the stirrer includes, for example, T. K. Homo Mixer (registered trademark) manufactured by PRIMIX Co., Ultra-Turrax (registered trademark) manufactured by IKA, and the like, and a colloid mill includes, for example, T. K. Mycolloider (registered trademark), T. K. Homomic Line Mill (registered trademark), and T. K. High Line Mill (registered trademark) manufactured by PRIMIX Co., and Static mixer (registered trademark), High-pressure microreactor (registered trademark), high-pressure homogenizer (registered trademark), etc. manufactured by NORITAKE CO., LIMITED.

By adopting the above-described dispersion treatment system, relatively fine particles enter the voids of relatively coarse particles, and a high density magnetic material can be obtained, having a higher filling property than that composed of coarse particles alone or fine particles alone, which is preferable.

As described above, the present invention provides the magnetic material capable of ensuring excellent electromagnetic wave absorption property in a wide temperature range and a wide frequency band.

### [4] Electromagnetic wave absorbing sheet according to the present invention and method for producing the same.

For producing the electromagnetic wave absorbing sheet according to the present invention, any conventionally known method for producing an electromagnetic wave absorbing sheet can be adopted.

That is, a radio wave absorber material (kneaded material) can be obtained by kneading the powder obtained by the above-described production process together with a polymer base material.

Here, as the polymer base material, various materials that satisfy heat resistance, flame retardancy, durability, mechanical strength, and electrical properties can be used depending on a use environment. For example, an appropriate material may be selected from resin (nylon or the like), gel (silicone gel or the like), thermoplastic elastomer, rubber or the like. Further, two or more kinds of polymer compounds may be blended to form a base material. An electromagnetic wave absorbing sheet is obtained by rolling the above electromagnetic wave absorber material (kneaded product) into a predetermined sheet thickness. However, if a dimensional accuracy is relaxed to some extent, the electromagnetic wave absorbing sheet can also be obtained by kneading the obtained magnetic powder and injection molding.

As described above, the present invention provides the electromagnetic wave absorbing sheet that can ensure excellent electromagnetic wave absorption property in a wide temperature range and a wide frequency band.

### Examples

### The present invention will be described more specifically hereafter, with reference to Examples.

### <Method for measuring particle size (epsilon iron oxide)>

A particle size of the epsilon iron oxide particles was obtained by observation with a transmission electron microscope (TEM). JEM-1011 manufactured by JEOL Ltd. was used for TEM observation.

Then, in a certain epsilon iron oxide particle, a rectangle that is circumscribed and has a smallest area is assumed, and a length of a long side of the rectangle was defined as a particle size (major axis) of the particles. Specifically, in a TEM photograph taken at a magnification of 100,000 times, 300 epsilon iron oxide particles whose entire outer edge portion was observed, were randomly selected, and the particle size (major axis) was measured. Then, an average value of the particle size was defined as an average particle size of the epsilon iron oxide particles.

### <Method for measuring particle size (hexagonal ferrite)>

The particle size of hexagonal ferrite was measured by a laser diffraction method using a dry method. Specifically a laser diffraction particle size distribution analyzer (HELOS&RODOS) was used for the laser diffraction method. The used lens was 200 mm, and a dispersion pressure was measured at 0.5 MPa.

According to the method, a volume particle size of hexagonal ferrite was measured, and in a volume-based cumulative particle size distribution, the value at 50% was taken as the average particle size (D50 particle size), and the value at 90% was taken as D90 particle size.

### <Method for measuring true density>

True density of epsilon iron oxide and hexagonal ferrite was measured and the measurement was repeated 5 times by substituting with helium gas, using Accupyc II 1340 series (standard type) manufactured by Micromeritex. A gas introduction pressure was measured at a setting of 19.5 psig.

### <Method for measuring magnetic properties>

The magnetic properties of the magnetic material were measured using a VSM device (VSM-5S) manufactured by Toei Industry Co., Ltd. with an applied magnetic field of 1194 kA/m (15 kOe).

### <Method for measuring BET specific surface area>

BET specific surface areas of epsilon iron oxide and hexagonal ferrite were obtained by BET one-point method using Macsorb model-1210 manufactured by Mountech Co., Ltd.

<Method for measuring crystallite size (Dx)>

A crystallite size (Dx) of hexagonal ferrite was calculated by measuring an X-ray diffraction pattern using an X-ray diffractometer (Ultima IV) manufactured by Rigaku Co., Ltd., and using a diffraction peak of a hexagonal ferrite (114) plane, and using Scherrer's formula.

### (Example 1)

### <Preparation of epsilon iron oxide>

Pure water 32800.16 g, 2436.16 g of ferric nitrate (III) nonahydrate with a purity of 99.7%, 618.74 g of gallium (III) nitrate solution with a gallium concentration of 9.33%, 57.06 g of titanium (IV) sulfate n-hydrate with a titanium element content of 15.1 mass%, and 54.01 g of cobalt (II) nitrate hexahydrate with a purity of 97% were put into 45L reaction tank, and the mixture was mixed while mechanically stirring with a stirring blade under an atmosphere of 30° C, to obtain a mixed solution. The molar ratio of the substitution element ions in the obtained mixed solution was Fe:Ga:Ti:Co=1.67:0.23:0.05:0.05, respectively.

Ammonia solution 2508.61 g with a concentration of 22.5% was continuously added for 10 minutes, while mechanically stirring the mixed solution under an atmosphere of 30° C with a stirring blade, and the stirring was continued for another 30 minutes to obtain a precursor slurry.

Tetraethoxysilane (TEOS) 4484.14 g was continuously added as a silicon compound for 10 minutes while mechanically stirring the precursor slurry, and the stirring was continued for about 1 day. Then, the obtained stirred slurry was subjected to solid-liquid separation, and the separated solid component was washed and then collected as a cake.

The collected cake was dried and then pulverized to obtain a dry powder. The obtained dry powder was subjected to heat treatment at 1088° C. for 4 hours in a furnace in an air atmosphere, to obtain a substitution type epsilon iron oxide powder coated with silicon oxide.

The obtained substitution type epsilon iron oxide powder coated with silicon oxide was put into a 17.59% NaOH aqueous solution which was an alkaline aqueous solution, and the mixture was stirred at about 60° C for 24 hours to remove the silicon oxide on the surface of the substitution type epsilon iron oxide particles. The slurry obtained after the removal treatment was subjected to centrifugal separation treatment at 3000 rpm for 10 minutes using a centrifuge to perform solid-liquid separation.

After removing a supernatant liquid from the obtained solid-liquid separated product, pure water was added to re-disperse the slurry.

Then, the re-dispersed slurry was subjected to a centrifugal separation treatment at 5000 rpm for 5 minutes and subjected to solid-liquid separation to obtain a solid-liquid separated product. After removing the supernatant liquid from the obtained solid-liquid separated product, pure water was added to re-disperse the slurry. Then, the re-dispersed slurry was subjected to a centrifugal separation treatment at 8000 rpm for 15 minutes to perform solid-liquid separation, to obtain a solid-liquid separated product. After drying the solid component of the obtained solid-liquid separated product, the powder was pulverized to obtain GaTiCo substitution type epsilon iron oxide (ε-Ga_{0.21}Ti_{0.05}Co_{0.05}Fe_{1.69}O₃) powder which was epsilon iron oxide according to Example 1.

Table 1 shows a composition ratio (molar ratio) of the prepared GaTiCo substitution type epsilon iron oxide, an analysis value by ICP, a powder property (BET value), and a magnetic property measured by VSM apparatus.

Further, the true density of this epsilon iron oxide powder obtained by a gas substitution method was 4.73 g/cm³, and an average particle size of the particles measured by TEM was 18.9 nm.

Then, it was confirmed that the slope of the change in coercive force (Hc) dependent on temperature was negative in a range of room temperature to 60° C.

**[Table 1]**

| **Composition ratio (molar ratio)** | | | | **ICP analysis value (mass%)** | | | | **Powder property** | **Magnetic property** | | | |
|---|---|---|---|---|---|---|---|---|---|---|---|---|
| **Fe** | **Ga** | **Ti** | **Co** | **Fe** | **Ga** | **Ti** | **Co** | **BET** | **AAA** | **He** | **σs** | **σr** |
| | | | | | | | | **(m²/g)** | **(°C)** | **(Oe)** | **(emu/g)** | **(emu/g)** |
| **1.69** | **0.21** | **0.051** | **0.049** | **53.9** | **8.35** | **1.4** | **1.65** | **64.1** | **25** | **4416** | **17.6** | **9.4** |

| | | | | | | | | | | | | |
|---|---|---|---|---|---|---|---|---|---|---|---|---|
| **AAA= Measurement temperature** | | | | | | | | | | | | |

### <Preparation of hexagonal ferrite>

Strontium carbonate 468.29 g with a purity of 99%, 2675 g of iron(III) oxide with a purity of 99%, 264.16 g of aluminum oxide with a purity of 99.9%, and 92.98 of barium chloride dihydrate with a purity of 99% were collected, and after mixing with a high speed mixer, the mixture was further mixed with a vibration mill to obtain a mixed powder. The obtained mixed powder was put in the high speed mixer again, and stirred while adding water, and the mixed powder was granulated into pellets, to obtain a molded body.

The obtained molded body was placed in a roller hearth type electric furnace and fired by holding it at 1290° C for 4.5 hours in the air atmosphere, to obtain a fired product.

The obtained fired product was roughly pulverized with a jaw crusher and then pulverized with a hammer mill, to obtain a pulverized product. The obtained pulverized product was placed in an attritor and wet-pulverized for 5 minutes using water as a solvent, to obtain a slurry. The obtained slurry was filtered, dried overnight and then dry-pulverized with a hammer mill, to prepare strontium ferrite, which was hexagonal ferrite according to Example 1.

Table 2 shows a composition ratio (molar ratio) of the prepared hexagonal ferrite, an analysis value by ICP, powder property (BET value) and a magnetic property measured by VSM apparatus, and Table 3 shows a particle size distribution.

Further, the true density of this hexagonal ferrite powder calculated by the gas substitution method was 5.01 g/cm³.

Then, it was confirmed that the slope of the change in coercive force (Hc) dependent on temperature was positive in a range of room temperature to 60° C.

**[Table 2]**

| **Composition ratio (molar ratio)** | | | | **ICP analysis value (mass%)** | | | | **Powder propety** | **Magnetic property** | | | |
|---|---|---|---|---|---|---|---|---|---|---|---|---|
| **Sr** | Fe | **Al** | **Ba** | **Sr** | **Fe** | **Al** | **Ba** | **BET** | **AAA** | **Hc** | **σs** | **σr** |
| | | | | | | | | **(m²/g)** | **(°C)** | **(Oe)** | **(emu/g)** | **(emu/g)** |
| **1.0** | **12.2** | **2.0** | **0.2** | **7.23** | **56.39** | **4.53** | **1.88** | | **25** | **2742** | **24.9** | **38.1** |

| | | | | | | | | | | | | |
|---|---|---|---|---|---|---|---|---|---|---|---|---|
| **AAA = Measurement temperature** | | | | | | | | | | | | |

**[Table 3]**

| **Particle size** | | | | |
|---|---|---|---|---|
| **Crystallite size (Dx)** | **D10** | **D50** | **D90** | **Peak particle size** |
| **(nm)** | **(µm)** | **(µm)** | **(µm)** | **(µm)** |
| **92.3** | **2.56** | **13.3** | **30.5** | **17.5** |

### <Preparation of magnetic material>

GaTiCo substitution type epsilon iron oxide 0.5 g obtained by the above process and 1.0 g of strontium ferrite were weighed in a weight ratio of 1:2, which were then well mixed for 10 minutes using an agate mortar.

After adding 15 mL water to the obtained mixture, the mixture was subjected to ultrasonic wave irradiation for 10 minutes, and further, loaded into a homogenizer (BRANSON ultrasonic homogenizer model 250D), and subjected to mixing by the homogenizer which was operated for 10 minutes with its output set to 10%, to obtain a mixture.

Ammonium sulfate 2.0 g was added to the obtained mixture, and the mixture was transferred to a centrifuge tube, using 5 mL water. Then, the supernatant was removed by centrifugation at 14000 rpm for 5 minutes. Thereafter, 20 mL water was added, and the mixture was centrifuged again at 14000 rpm for 5 minutes, and a solid component is taken out by removing the supernatant.

Before the water contained in the obtained solid component dries, 0.54 g of the solid component is filled in a 10 mmφ metal container, molded at 110 °C for 1 hour while adding 1.5t weight, and after cooling to room temperature, a solid sample, which is a pellet-shaped magnetic material according to Example 1, was obtained. The obtained solid sample had a thickness of 1.0 mm and a weight of 0.27 g, and a filling rate calculated was 67.4%.

### <Property measurement of magnetic material>

Electromagnetic wave absorption properties of the magnetic material sample according to Example 1 were measured using terahertz time domain spectroscopy. Specifically, a transmission absorption spectrum was obtained by injecting terahertz pulsed light into the sample and detecting a transmitted light. Then, a temperature dependence of the absorption property (unit: decibel) of the electromagnetic wave having a frequency of 74.5 to 78.5 GHz in a temperature range of -160 to +140°C of the sample and its surroundings, was measured by modulating the temperature of an aperture using a cryostat, the temperature being the temperature of the aperture to which the sample is attached by silver paste.

Table 4 shows the measurement results.

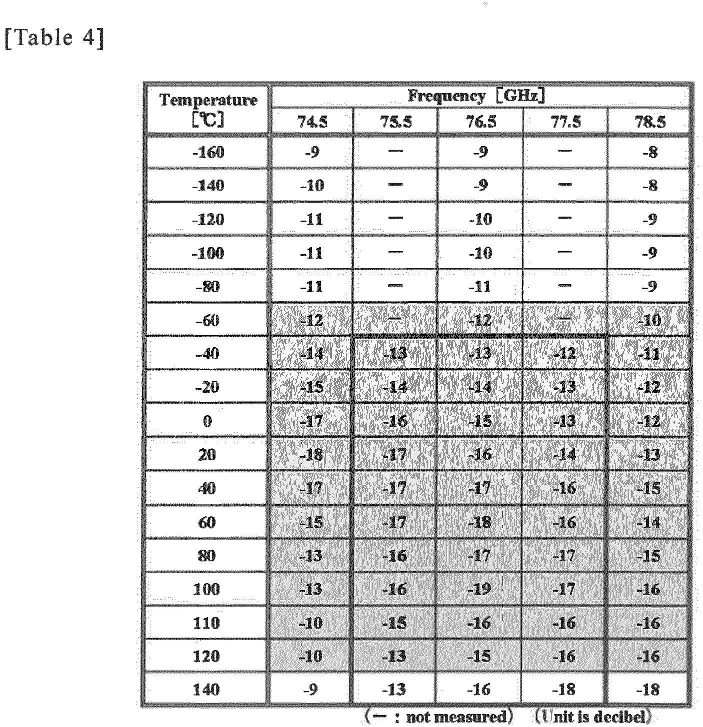

### (Comparative Example 1)

A magnetic material sample according to Comparative Example 1 was prepared using only the strontium ferrite prepared in Example 1 described above.

Specifically, the strontium ferrite 1.5 g prepared in Example 1 was mixed for 10 minutes using an agate mortar, then, 15 mL water was added thereto, and the mixture was irradiated with ultrasonic waves for 10 minutes, and loaded into the homogenizer described in Example 1, and subjected to the same operation as in Example 1, to obtain a mixture according to Comparative Example 1.

The obtained mixture according to Comparative Example 1 was transferred to a centrifuge tube using 10 mL water, and subjected to centrifugation at 14000 pm for 5 minutes, to obtain a solid component by removing the supernatant.

Before the water contained in the obtained solid component dries, about 0.38 g of the solid component is filled in a 10 mmφ metal container, molded for 1 hour while adding 1.5t weight at 110°C, and after cooling to room temperature, a solid sample, which is a pellet-shaped magnetic material according to Comparative Example 1, was obtained. The thickness of the obtained solid sample was 1.0 mm, the weight was 0.20 g, and the filling rate calculated was 51.5%.

Electromagnetic wave absorption property of the obtained magnetic material sample according to Comparative Example 1 was measured in the same manner as in Example 1.

Table 5 shows the measurement results.

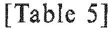

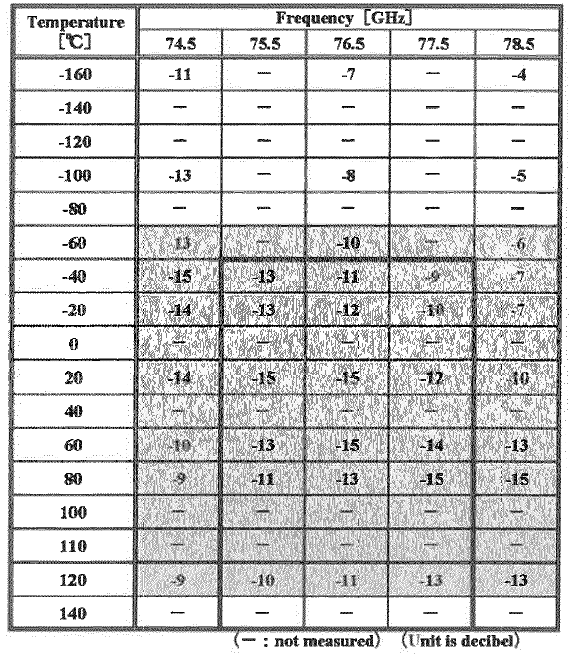

### (Conclusion)

The electromagnetic wave absorption properties of the magnetic material samples shown in Tables 4 and 5 are compared, and it is found that the electromagnetic wave absorption property of the magnetic material sample of Example 1 is more excellent than the electromagnetic wave absorption property of the magnetic material sample of Comparative Example 1 according to a conventional technique.

That is, first, the magnetic material sample of Example 1 showed a minimum value of -8 decibels (-160 °C, 78.5 GHz) and a maximum value of -19 decibels (+100 °C, 76.5 GHz) in a temperature range of -160 to +140 °C, and in an electromagnetic wave frequency range of 74.5 to 78.5 GHz. In contrast, the magnetic material sample of Comparative Example 1 showed a minimum value of -4 decibels (-140 to -160 °C, 78.5 GHz) and a maximum value of -15 decibels (+20 to +80 °C, 75.5 to 77.7 GHz in the same range.

Next, the magnetic material sample of Example 1 showed a minimum value of -10 decibels (-60 °C, 78.5 GHz) and a maximum value of -19 decibels (+100 °C, 76.5 GHz) in a temperature range of -60 to +120°C, and in an electromagnetic wave frequency range of 74.5 to 78.5 GHz (Tables 4 and 5 with gray background) which are industrially important from a perspective of ensuring reliability of a millimeter-wave radar system for vehicles. In contrast, the magnetic material sample of Comparative Example 1 showed a minimum value of -6 decibels (-60 °C, 78.5 GHz) and a maximum value of -15 decibels (+20 to +80 °C, 75.5 to 77.7 GHz) in the same range.

Further, the magnetic material sample of Example 1 had a minimum value of -12 decibels (-40 °C, 77.5 GHz) and a maximum value of -19 decibels (+100 °C, 76.5 GHz) in a temperature range of -40 to +140 °C, electromagnetic wave frequency range of 75.5 to 77.5 GHz (in Tables 4 and 5, surrounded by thick ruled lines). In contrast, the magnetic material sample of Comparative Example 1 showed a minimum value of -9 decibels (-40 °C, 77.5 GHz) and a maximum value of -15 decibels (+20 to +80 °C, 75.5 to 77.7 GHz) in the same range.

Even under the conditions in any of the three temperature ranges and frequency ranges described above, the magnetic material sample of Example 1 showed more excellent electromagnetic wave absorption property than the magnetic material sample of Comparative Example 1.

## Claims

1. A magnetic material as a mixture of a magnetic material having positive slope of change in coercive force dependent on temperature, and a magnetic material having negative slope of change in coercive force dependent on temperature.

2. A magnetic material containing epsilon iron oxide and hexagonal ferrite.

3. A magnetic material consisting of epsilon iron oxide and hexagonal ferrite.

4. A method for producing a magnetic material, comprising:
mixing epsilon iron oxide, hexagonal ferrite, and a dispersion medium and performing a dispersion treatment to obtain a mixture; and
performing solid-liquid separation operation on the mixture to recover a solid component.

5. An electromagnetic wave absorbing sheet containing the magnetic material according to any one of claims 1 to 3.
